# EUROPEAN PATENT APPLICATION

(11) **EP 1 113 283 A2**
(43) Date of publication of application: **04.07.2001**
(21) Application number: 00311656.3
(22) Date of filing: 22.12.2000
(51) Int. Cl.: G01R 33/10

(54) **Magnetic field measuring equipment**

(30) Priority: 27.12.1999 JP 36977499
(71) Applicant: Delta Tooling Co., Ltd., Hiroshima 736-0084 (JP)
(72) Inventor: Kawasaki, Seiji, c/o Delta Tooling Co., Ltd., Hiroshima-shi, Hiroshima 736-0084 (JP); Enoki, Yoshimi, c/o Delta Tooling Co., Ltd., Hiroshima-shi, Hiroshima 736-0084 (JP); Wagata, Shigeki, c/o Delta Tooling Co., Ltd., Hiroshima-shi, Hiroshima 736-0084 (JP); Nakahira, Hiroshi, c/o Delta Tooling Co., Ltd., Hiroshima-shi, Hiroshima 736-0084 (JP); Yamane, Hideyuki, c/o Delta Tooling Co., Ltd., Hiroshima-shi, Hiroshima 736-0084 (JP); Tao, Hiroyuki, Kuri-shi, Hiroshima 737-0901 (JP)
(74) Representative: Bubb, Antony John Allen

(57) **Abstract**

A magnetic field measuring equipment is capable of accurately and rapidly measuring a magnetic field produced in a three-dimensional space around a measured object (object to be measured) and visually displaying results of the measurement. The magnetic field measuring equipment includes a measuring instrument (10) including a magnetic sensor (14) arranged so as to be relatively movable in three dimensional directions around a measured object (40), a computer (20) including a data processing means for subjecting a magnetic field of the measured object to processing so as to permit the magnetic field to be visually displayed, on the basis of three-dimensional magnetic force data of the measured object measured by the measuring instrument, and a display (30) acting as an output means for outputting results of processing by the data processing means. Such construction permits a magnetic field produced in a three-dimensional space around the measured object to be accurately and rapidly measured while eliminating problems of the prior art that it renders alignment of the measuring points difficult and It requires much time for the measurement.

## Description

### BACKGROUND OF THE INVENTION

This invention relates to a magnetic field measuring equipment, and more particularly to a magnetic field measuring equipment which permits visual display of a magnetic field produced around an object which is to be measured.

Measurement of a magnetic field produced around an object to be observed (hereinafter referred to as "observed object") such as, for example, a permanent magnet, an electric equipment having a magnet incorporated therein or the like has been conventionally carried out by means of a suitable measuring unit such as a fluxmeter, a Gauss meter or the like, wherein a sensor such as a hall device or the like is positioned at each of predetermined measuring points around the measured object, resulting in manually carrying out the measurement while manually varying the measuring points.'

Then, magnetic flux density measured by the measuring unit is plotted for every measuring point, to thereby permit a magnetic field produced around the measured object to be visibly recognized.

However, in the conventional magnetic field measurement described above, the sensor is manually moved to the measuring points, so that positional alignment or registration of the sensor with each of the measuring points may be difficult and troublesome, resulting in the measurement requiring much time and labor. Such a disadvantage is amplified when the number of measuring points is increased for obtaining detailed data.

Also, display of results of the measurement requires operation of reading values measured by the measuring unit and then manually plotting the values. Unfortunately, this causes much time and labor to be required for visibly displaying the magnetic field.

### SUMMARY OF THE INVENTION

The present invention has been made in view of the foregoing disadvantage of the prior art.

Accordingly, it is an object of the present invention to provide a magnetic field measuring equipment which is capable of accurately and rapidly measuring a magnetic field produced in a three-dimensional space around a measured object.

It is another object of the present invention to provide a magnetic field measuring equipment which is capable of permitting results of measurement of a magnetic field to be visually displayed.

In accordance with the present invention, a magnetic field measuring equipment is provided. The magnetic field measuring equipment includes a measuring instrument including a magnetic sensor arranged so as to be relatively movable in three-dimensional directions around an object to be measured or a measured object, a data processing means for subjecting a magnetic field of the measured object to processing so as to permit the magnetic field to be visually displayed, on the basis of three-dimensional magnetic force data of the measured object measured by the measuring instrument, and an output means for outputting results of processing by the data processing means.

In a preferred embodiment of the present invention, the measuring instrument includes a frame structure, an arm arranged so as to be movable in the three-dimensional directions relatively to the frame structure, a magnetic sensor supported on the arm, a magnetic flux density measuring unit for outputting results of detection by the magnetic sensor, and a control section constructed so as to set parameters on three axes of a measuring position by the magnetic sensor and control movement of the arm.

In a preferred embodiment of the present invention, the data processing means includes a data read means for reading the three-dimensional magnetic force data of the measured object measured by the measuring instrument and a display processing means for analyzing the three-dimensional magnetic force data read by the data read means to carry out processing thereof in conformity to display desired.

In a preferred embodiment of the present invention, the display of the three-dimensional magnetic force data processed by the display processing means is carried out in the form of vector display which indicates a direction of magnetic force lines by a direction of vector lines and indicates intensity of a magnetic field by at least one of a difference in length of vector lines, a difference in color and a difference in shade.

In a preferred embodiment of the present invention, the display of the three-dimensional magnetic force data processed by the display processing means is carried out in the form of a color diagram which indicates intensity of a magnetic field by at least one of a difference in color and a difference in shade.

In a preferred embodiment of the present invention, the display of the three-dimensional magnetic force data processed by the display processing means is carried out in the form of at least one of sectional display and stereo display.

### BRIEF DESCRIPTION OF THE DRAWINGS

These and other objects and many of the attendant advantages of the present invention will be readily appreciated as the same becomes better understood by reference to the following detailed description when considered in connection with the accompanying drawings; wherein :
Fig. 1 is a schematic view showing an embodiment of a magnetic field measuring equipment according to the present invention;
Fig. 2 is a perspective view showing a measuring instrument incorporated in the magnetic field measuring equipment of Fig. 1;
Fig. 3 is a flow chart showing processing carried out in the magnetic field measuring equipment of Fig. 1;
Fig. 4 is a schematic perspective view showing a measured object used in Example 1;
Fig. 5(a) is a diagrammatic view showing a magnetic field on a plane A in Fig. 4 which is displayed by means of vector lines;
Fig. 5(b) is a color diagram of the magnetic field shown in Fig. 5(a);
Fig. 5(c) is a color diagram of the magnetic field shown in Fig. 5(a), wherein boundaries between colors are definitely defined;
Fig. 6 is a schematic perspective view showing a measured object used in Example 2;
Fig. 7(a) is a diagrammatic view showing a magnetic field on a plane A in Fig. 6 which is displayed by means of vector lines;
Fig. 7(b) is a diagrammatic view showing a magnetic field on a plane B in Fig. 6 which is displayed by means of vector lines;
Fig. 7(c) is a diagrammatic view showing a magnetic field on a plane C in Fig. 6 which is displayed by means of vector lines;
Fig. 7(d) is a diagrammatic view showing a magnetic field on a plane D in Fig. 6 which is displayed by means of vector lines;
Fig. 8(a) is a perspective view showing a measured object used in Example 3;
Fig. 8(b) is a diagrammatic view showing a magnetic field on a plane A in Fig. 8(a) which is displayed by means of vector lines;
Fig. 9(a) is a perspective view showing another measured object used in Example 3;
Fig. 9(b) is a diagrammatic view showing a magnetic field on a plane A in Fig. 9(a) which is displayed by means of vector lines;
Fig. 10(a) is a perspective view showing a further measured object used in Example 3; and
Fig. 10(b) is a diagrammatic view showing a magnetic field on a plane A in Fig. 10(a) which is displayed by means of vector lines.

### DETAILED DESCRIPTION OF THE PREFERRED EMBODIMENT

Now, a magnetic field measuring equipment according to the present invention will be described with reference to the accompanying drawings.

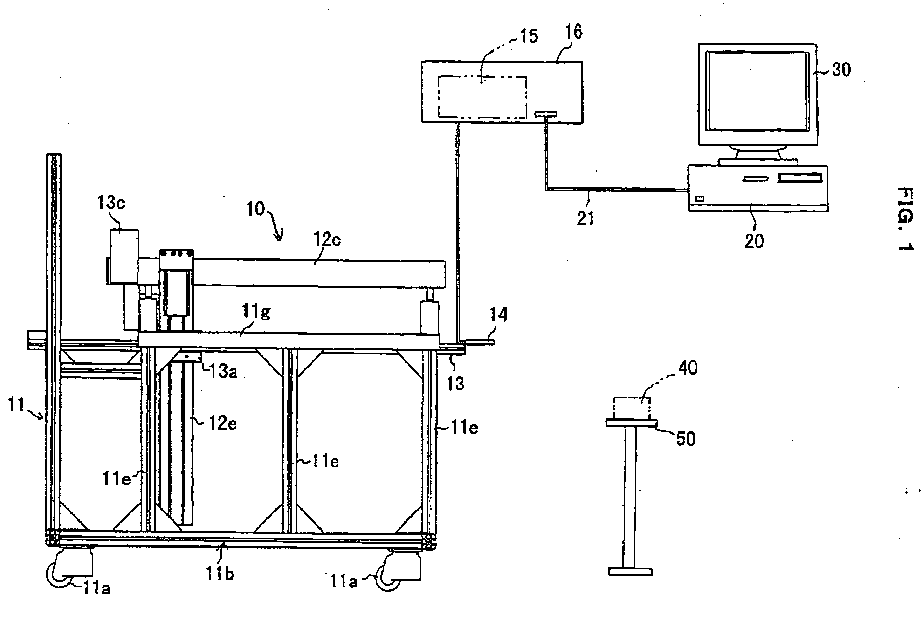

Referring first to Fig. 1, an embodiment of a magnetic field measuring equipment according to the present invention is illustrated. A magnetic field measuring equipment of the illustrated embodiment generally includes a measuring instrument 10. a computer 20 having a data processing means incorporated therein, and a display 30 acting as an output means.

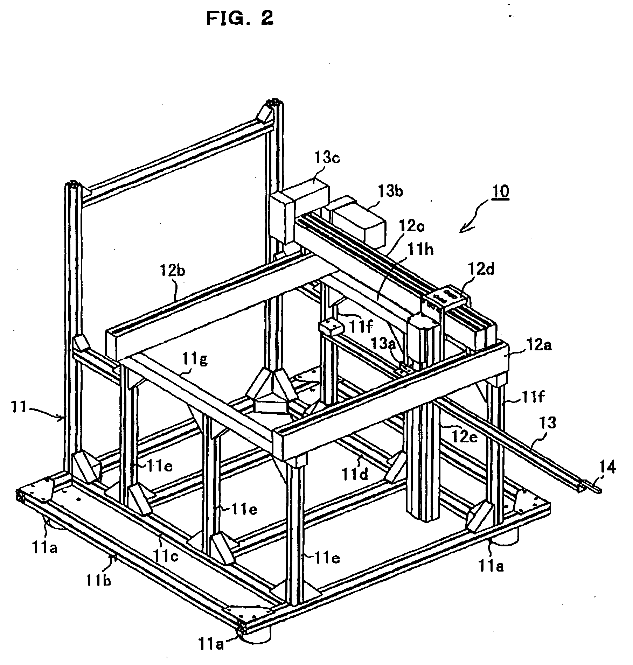

The measuring instrument 10, as shown in Fig. 2, is constituted by a frame structure 11, an arm 13 arranged so as to be movable in three-dimensional directions relatively to the frame structure 11, a magnetic sensor 14 supported on the arm 13, a control box 16 including a measuring unit for magnetic flux density and outputting results of detection by the magnetic sensor 14, and a control section for controlling movement or operation of the arm 13.

The frame structure 11 includes a base frame 11b arranged so as to be movable by means of casters 11a. The base frame 11b is assembled or constructed into a substantially square shape in plan and includes a pair of frame members 11c and 11d, which are , arranged opposite to each other and on which a plurality of support frames lie and 11f are arranged. The support frames lie are mounted on the frame member 11c, whereas the support frames 11f are mounted on the frame member lid. The support frames lie are mounted thereon with a horizontal frame 11g through which the support frames 11e are connected at an upper end thereof to each other. The support frames 11f arranged opposite to the support frames lie are mounted thereon with a horizontal frame llh through which the support frames 11f are connected at an upper end thereof to each other. The horizontal frames 11g and 11f are arranged in a manner to be opposite to each other.

The horizontal frames 11g and llh thus arranged opposite to each other have an X-axis rail 12a arranged between one ends thereof and an X-axis rail 12b arranged between the other ends thereof in a manner to extend in a direction perpendicular to the horizontal frames llg and 11h. The X-axis rails 12a and 12b have a Y-axis rail 12c supported thereon in a manner to extend in a direction perpendicular to the rails. Also, the Y-axis rail 12c is arranged so as to travel in an X-axis direction along the X-axis rails 12a and 12b. The Y-axis rail 12c has a Z-axis rail 12e supported thereon in a manner to be suspended therefrom or downwardly extend therefrom. The Z-axis rail 12e includes a travel section 12d arranged on the Y-axis rail 12c so as to travel thereon in a Y-axis direction. The Z-axis rail 12e has a connection member 13a of the arm 13 supported thereon so as to travel thereon in a Z-axis direction.

Such construction of the frame structure 11 permits the magnetic sensor 14 supported on the arm 13 to be moved in the X-axis direction with movement of the Y-axis rail 12c
along the X-axis rails 12a and 12b, in the Y-axis direction with movement of the travel section 12d of the Z-axis rail 12e along the Y-axis rail 12c and in the Z-axis direction with movement of the connection member 13a of the arm 13 in the Z-axis direction along the Z-axis rail 12e. This permits the magnetic sensor 14 to be moved in three-dimensional directions. In Fig. 2, reference character 13b indicates an X-axis actuator for operating or moving the Y-axis rail 12c in the X-axis direction and 13c is a Y-axis actuator for moving the Z-axis rail 12e in the Y-axis direction.

The measuring unit arranged in the control box 16 for measuring magnetic flux density is generally constituted by a Gauss meter 15. Thus, the magnetic sensor 14 is generally constituted by a hall device. Alternatively, a magnetic resistance device may be substituted for the hall device. The magnetic sensor 14 is fixedly arranged on a distal end of the arm 13. Such arrangement of the magnetic sensor 14 permits the magnetic sensor 14 to be spaced from the X-axis direction actuator 13b and Y-axis direction actuator 13c as much as possible, to thereby prevent the magnetic sensor 14 from being affected by magnets incorporated in the actuators 13b and 13c.

The control section for controlling the arm 13 or controlling driving of the X-axis direction actuator 13b and Y-axis direction actuator 13c is arranged in the control box 16. The computer 20 includes a storage device to which parameters about the amount of movement of the magnetic sensor 14 on the three axes are inputted. Any desired parameters are inputted to the storage device depending on a size of a measured object 40 and a configuration thereof, resulting in the control section in the control box 16 being fed with a command, leading to driving of the actuators 13b and 13c, so that the magnetic sensor 14 may be moved in three-dimensional directions around the measured object 40.

In the illustrated embodiment, the measured object 40 is a magnet. Alternatively, it is of course that the illustrated embodiment may be constructed so as to permit magnetic force data around an electric equipment having a magnet incorporated therein to be measured in three dimensional directions. Also, the measured object 40 is supported on a support member 50 arranged in front of the arm 13. The support member 50 may be arranged independently from the frame structure 11. Alternatively, it may be connected to any one of the frames and frame members constituting the frame structure 11 while being positioned forwardly of the arm 13.

The computer 20 is connected to the Gauss meter 15 though a communication line 21 and has a data processing means incorporated therein. More particularly, the Gauss meter 15 is fed with three-dimensional magnetic force data measured due to movement of the magnetic sensor 14 around the measured object 40. The data processing means includes a data read means for reading . the three-dimensional magnetic force data fed thereto, as well as a display processing means for analyzing the three-dimensional magnetic force data read, to thereby carrying out processing of the data in conformity to a display manner desired.

The display manner may be selected as desired. Display by a vector diagram is preferable because it exhibits good visibility. More specifically, the display may be carried out in such a manner that a direction of magnetic force lines is indicated by a direction of vector lines and intensity of a magnetic field is indicated by a difference in length of vector lines, a difference in color, a difference in shade or a combination thereof. Also, the vector diagram may be displayed in section on any plane along any direction within a range in which the magnetic sensor 14 is moved around the measured object 40. Alternatively, it may be set to permit stereo display to be carried out.

Further, intensity of a magnetic field may be displayed by means of a color diagram rather than the vector lines. More specifically, it may be displayed by means of a difference in color, a difference in shade or a so-called color classified pattern due to a combination thereof. In this instance, in order to indicate a direction of magnetic force lines in detail, the display may be carried out by superposing the vector lines on each other.

Results of processing by the data processing means may be outputted using an output means which may be constituted by any desired display means or printing means.

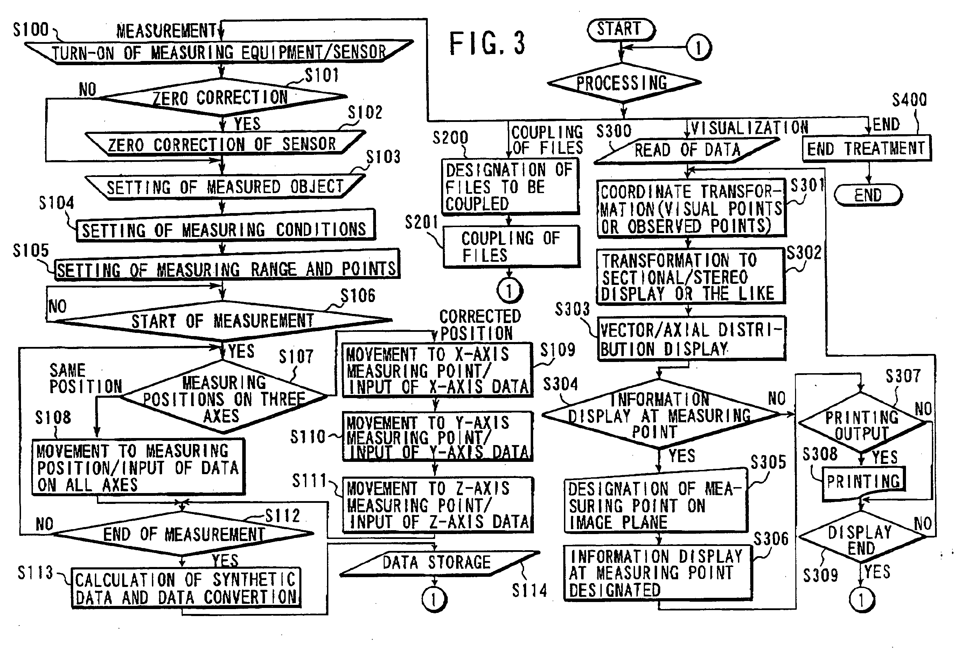

Now, processing in the illustrated embodiment will be described with reference to a flow chart of Fig. 3.

First of all, a processing program set in the computer 20 is executed. In the processing program, the data processing means which includes the data read means and display processing means described above is set.

When the processing program is started, menus of measurement, file coupling, data processing and end or termination are displayed on the display. Then, supposing that of the menus, the measurement menu is selected, a signal is fed to the control section, resulting in the Gauss meter 15 of the measuring instrument 10 being turned on (Step (hereinafter abbreviated as "S") 100). In this instance, when a hall device is used as the magnetic sensor 14, zero correction is carried out (S 101 and S 102).

Then, the measured object 40 is set on the support member 50 (S 103). Alternatively, setting of the measured object 40 on the support member 50 may be of course carried out before start of the processing program described above.

Then, measuring conditions such as a speed of movement of the arm 13, the number of times of measurement, measuring positions and the like are set (S 104). Likewise, a measuring range and the number of measuring points are set (S 105). Of course, setting of such measuring conditions may be carried out prior to zero correction of the magnetic sensor 14. Then, the measurement is started (S 106).

When the measurement is started, it is judged whether or not the measuring positions on the X-axis, Y-axis and Z-axis constitute the same position (S 107). When they are the same position, the arm 13 is moved so that the magnetic sensor 14 is located at the position. This permits magnetic sensor 14 to measure data on the three axes at the position (S 108).

On the contrary, when the measuring positions on the X-axis, Y-axis and Z-axis are different from each other, the arm 13 is moved so that first the magnetic sensor 14 is set at the measuring position on the X-axis, to thereby measure magnetic flux density on the X-axis (S 109). Thereafter, the magnetic sensor 14 is set at the measuring position on the Y-axis, resulting in measuring magnetic flux density on the Y-axis (S 110). Then, the magnetic sensor 14 is set at the measuring position on the Z-axis, to thereby measure magnetic flux density on the Z-axis (S 111).

Thus, when the measurement is terminated (S 112), data measured are fed to the computer 20, so that synthetic data on each of the axes may be calculated and subjected to data conversion (S 113). Then, the data thus converted are stored in a designated file in the computer 20 (S 114).

Subsequently, if required, the above-described operation is repeated while varying the measuring positions, so that the magnetic flux density may be measured at a plurality of points. Results of the measurement are stored in a designated file in the computer 20. Further, as required, the files described above are selectively subjected to designation for coupling, followed by coupling (S 200 and S 201).

Then, visualization of data is carried out. At this time, first of all, the data read means of the computer 20 designates files to be visualized and carries out reading of the data (S 300).

After the data are thus read, the data are subjected to coordinate transformation (S 301). The coordinate transformation is carried out for transformation of visual points or observed points to be displayed and may be set at points intended as desired.

Then, the display processing means is activated. At this time, a display manner is first selected. Any one of a variety of display manners may be set as desired. For example, it may be set so as to select sectional display at such a point as described above or stereo display (S 302). Also, vector display or color display due to a difference in color or a difference in shade may be selected as desired (S 303).

When any of the display manners described above is selected or designated, three-dimensional magnetic force data are indicated on the display acting as the output means according to the display manner designated. Then, it is selected whether or not display of information such as various information at a measuring point, a value of magnetic flux density or the like is carried out (S 304). When display of information at the measuring point is carried out, the measuring point is designated on the display (S 305), resulting in information such as magnetic flux density at the measuring point or the like being displayed.

When information at the measuring point is displayed (S 306) or display of information at the measuring point is not selected, it is selected whether or not printing output is carried out (S 307). When it is designated that the printing output is carried out, information indicated on the display is outputted to a printer (S 308). When the operation described above is completely terminated, an end treatment is selected (S 400).

The invention will be understood more readily with reference to the following examples; however, these examples are intended to illustrate the invention and are not construed to limit the scope of the invention.

### Example 1

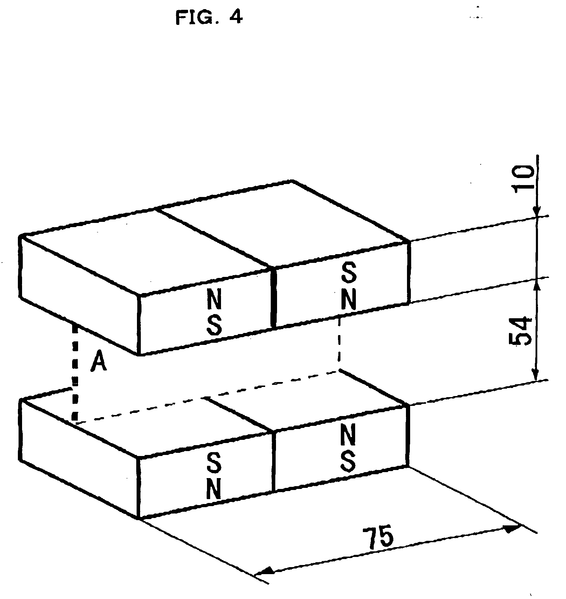

As shown in Fig. 4, two bipolar magnets each formed into dimensions of 75mm in length, 75mm in width and 10mm in thickness were supported on the support member 50 while keeping different poles thereof opposite to each other and being spaced from each other at an interval of 54mm, resulting in measurement for three-dimensional magnetic force data being carried out.

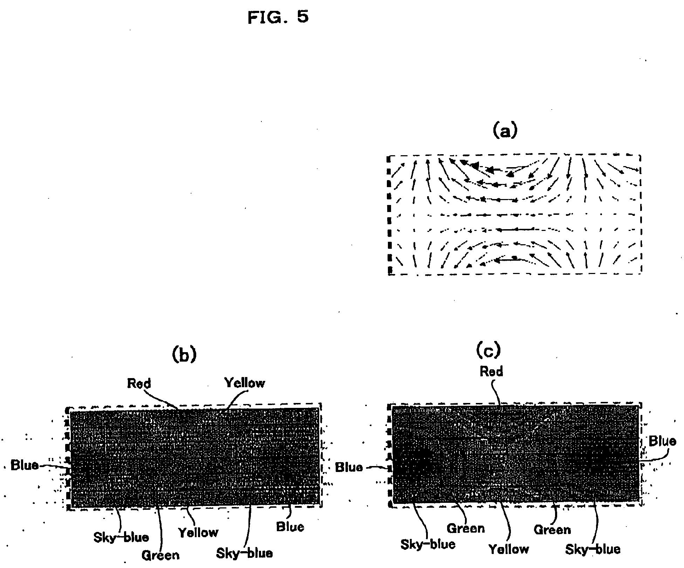

Then, a magnetic flux distribution on a plane A in Fig. 4 was displayed in the form of vector display as in Fig. 5(a). In Fig. 5(a), an arrow indicates a magnetic flux direction and a difference in intensity of magnetic flux density is displayed by a difference in length and a difference in shade. Also, although not shown, color display permits a difference in intensity of magnetic flux density to be displayed by a difference in color.

In Fig. 5(b), a magnetic flux distribution on the plane A is displayed by only a difference in color, wherein a portion of the plane A which is increased in magnetic flux density is indicated at red and a portion thereof which is reduced in magnetic flux density to the lowest level is indicated at blue. A portion of the plane A which has intermediate magnetic flux density is indicated at green. Magnetic flux density between red and green is indicated at yellow and that between blue and green is indicated at sky-blue. Also, color classification is carried so that each adjacent two colors each are gradually shifted toward the color adjacent thereto depending on intensity of the magnetic flux density.

In Fig. 5(c), a difference in intensity of the magnetic flux density is indicated by color classification as in Fig. 5(b). However, in Fig. 5(c), the magnetic flux density is classified into predetermined ranges depending on intensity thereof, resulting in a difference in intensity thereof being rendered distinct.

As will be noted from Figs. 5(a) to 5(c), the example permits a magnetic flux distribution around the measured object to be displayed in various display manners on the basis of all points.

### Example 2

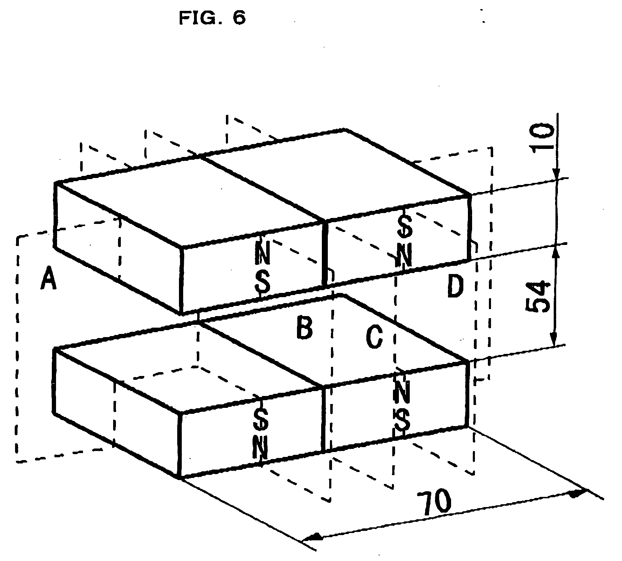

As shown in Fig. 6, two bipolar magnets each formed into dimensions of 70mm in length, 70mm in width and 10mm in thickness were supported on the support member 50 while keeping different poles thereof opposite to each other and being spaced from each other at an interval of 54mm, resulting in measurement for three-dimensional magnetic force data being carried out.

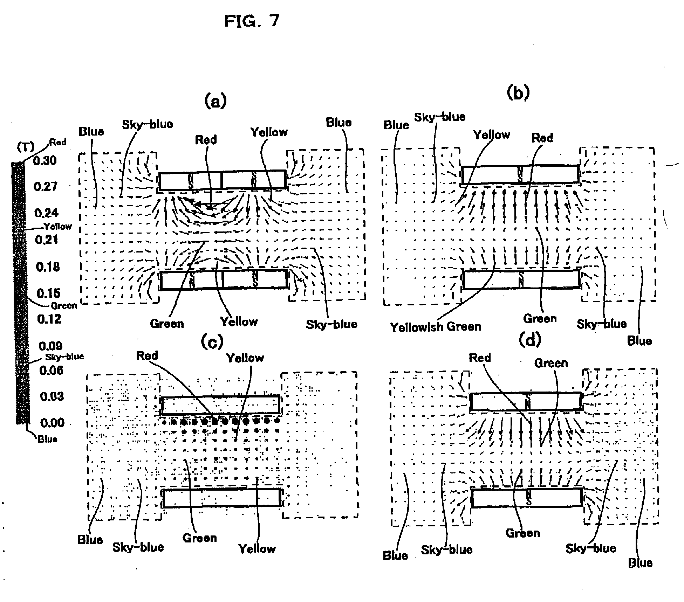

Then, a magnetic flux distribution on each of planes A, B and C in Fig. 6 was displayed in the form of vector display as shown in Fig. 7. In Fig. 7, an arrow indicates a magnetic flux direction and a difference in intensity of magnetic flux density is displayed by a difference in length and a difference in color. The intensity of the magnetic flux density is set between 0.00 T (Tesla) and 0.30 T, wherein red indicates the highest intensity and blue indicates the lowest intensity, between which the intensity is gradually reduced from red through yellow, green and sky-blue to blue in order.

### Example 3

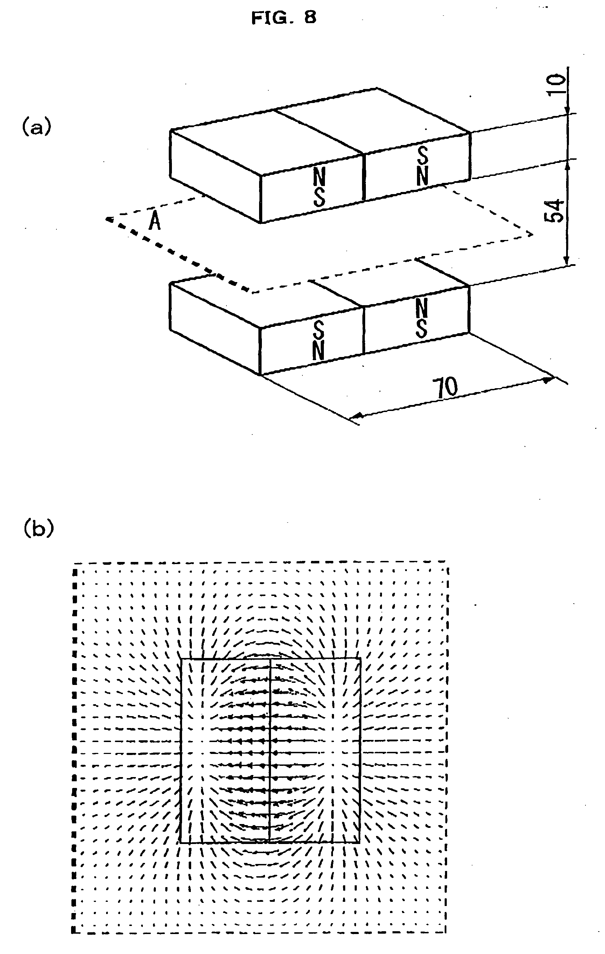

On the three-dimensional magnetic force data obtained in Example 2 described above, a magnetic flux distribution was measured on the plane A parallel to opposite surfaces of the two magnets at an intermediate position between the magnets spaced from each other, as shown in Fig. 8(a).

Results of the measurement were as shown in Fig. 8(b), wherein the distribution is indicated by monochrome vector lines.

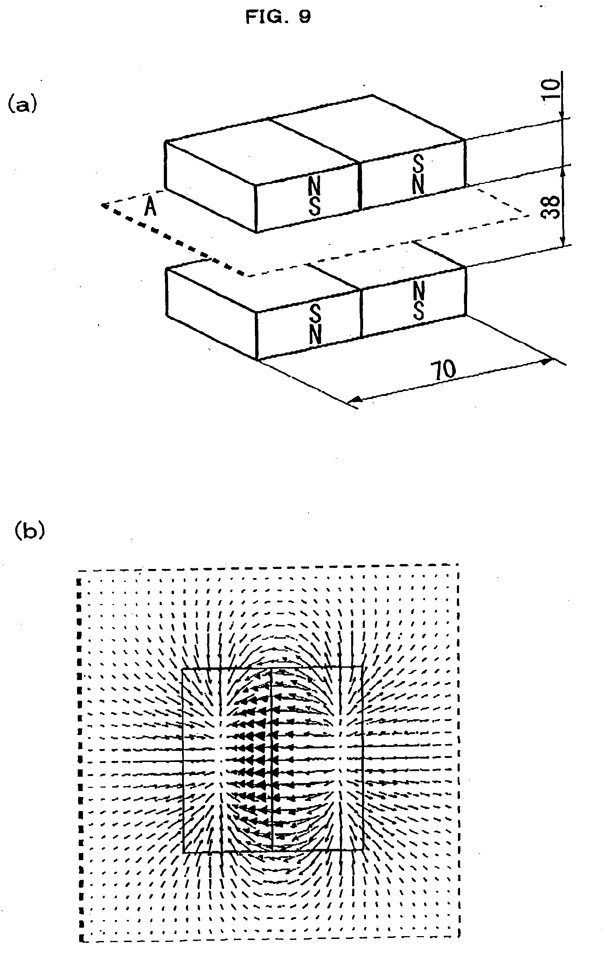

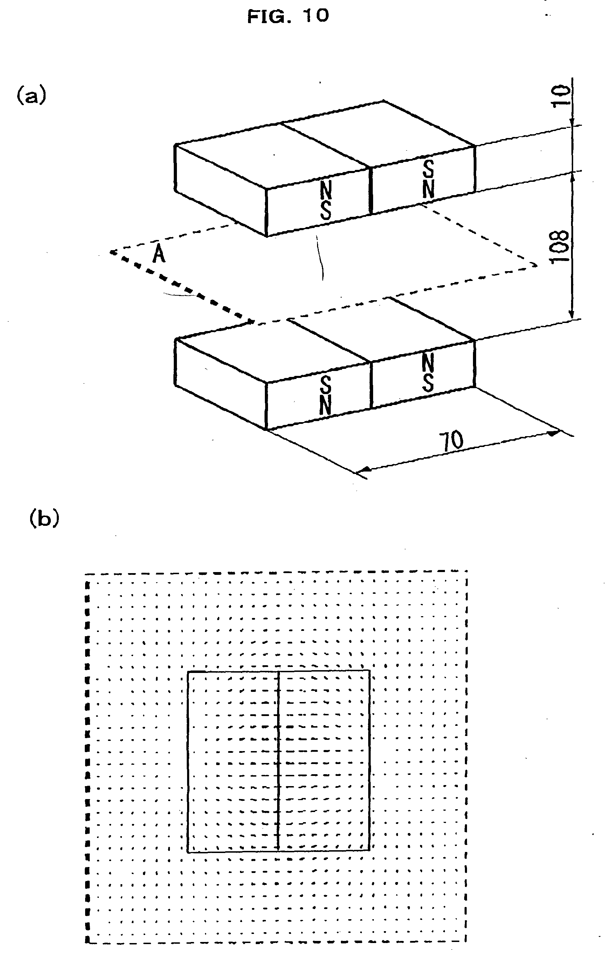

Also, Figs. 9 and 10 show magnetic flux distributions on the plane A parallel to the opposite surfaces of the two magnets at an intermediate position between the magnets spaced from each other at intervals 38mm and 108mm, respectively. The magnetic flux distributions each are indicated by vector lines. Figs. 9 and 10 clearly indicate that a variation in interval between the magnets substantially affects the magnetic flux density.

As can be seen form the foregoing, the magnetic field measuring equipment of the present invention includes the measuring instrument including the magnetic sensor arranged so as to be relatively movable in the three-dimensional directions around the measured object, the data processing means for subjecting a magnetic field of the measured object to processing so as to permits the magnetic field to be visually displayed, on the basis of three-dimensional magnetic force data of the measured object measured by the measuring instrument, and the output means for outputting results of processing by the data processing means. Such construction of the present invention permits a magnetic field produced in a three-dimensional space around the measured object to be accurately and rapidly measured while eliminating problems of the prior art that it renders alignment of the measuring points difficult and it requires much time for the measurement. Also, the data processing means and output means permits results of the measurement to be visually displayed, so that visualization of the magnetic field may be readily and rapidly carried out as compared with the prior art wherein the results are manually plotted.

While a preferred embodiment of the invention has been described with a certain degree of particularity with reference to the drawings, obvious modifications and variations are possible in light of the above teachings. It is therefore to be understood that within the scope of the appended claims, the invention may be practiced otherwise than as specifically described.

## Claims

1. A magnetic field measuring equipment comprising:
a measuring instrument including a magnetic sensor arranged so as to be relatively movable in three-dimensional directions around a measured object:
a data processing means for subjecting a magnetic field of the measured object to processing so as to permit the magnetic field to be visually displayed, on the basis of three-dimensional magnetic force data of the measured object measured by said measuring instrument; and
an output means for outputting results of processing by said data processing means.

2. A magnetic field measuring equipment as defined in claim 1, wherein said measuring instrument includes:
a frame structure;
an arm arranged so as to be movable in the three-dimensional directions relatively to said frame structure;
a magnetic sensor supported on said arm;
a magnetic flux density measuring unit for outputting results of detection by said magnetic sensor; and
a control section constructed so as to set parameters on three axes of a measuring position by said magnetic sensor and control movement of said arm.

3. A magnetic field measuring equipment as defined in claim 1 or 2, wherein said data processing means includes:
a data read means for reading the three-dimensional magnetic force data of the measured object measured by said measuring instrument; and
a display processing means for analyzing the three-dimensional magnetic force data read by said data read means to carry out processing thereof in conformity to display desired.

4. A magnetic field measuring equipment as defined in claim 3, wherein the display of the three-dimensional magnetic force data processed by said display processing means is carried out in the form of vector display which indicates a direction of magnetic force lines by a direction of vector lines and indicates intensity of a magnetic field by at least one of a difference in length of vector lines, a difference in color and a difference in shade.

5. A magnetic field measuring equipment as defined in claim 3, wherein the display of the three-dimensional magnetic force data processed by said display processing means is carried out in the form of a color diagram which indicates intensity of a magnetic field by at least one of a difference in color and a difference in shade.

6. A magnetic field measuring equipment as defined in claim 3, wherein the display of the three-dimensional magnetic force data processed by said display processing means is carried out in the form of at least one of sectional display and stereo display.
